# EUROPÄISCHE PATENTSCHRIFT

(11) **EP 1 088 309 B1**
(45) Veröffentlichungstag und Bekanntmachung des Hinweises auf die Patenterteilung: **18.09.2002**
(21) Anmeldenummer: 99938150.2
(22) Anmeldetag: 09.06.1999
(51) Int. Cl.: G11C 11/22

(54) **SCHREIB- UND LESEVERFAHREN FÜR EINEN FERROELEKTRISCHEN SPEICHER**
WRITING AND READING METHOD FOR FERROELECTRIC MEMORY
PROCEDE D'ECRITURE ET DE LECTURE POUR UNE MEMOIRE FERRO LECTRIQUE

(30) Priorität: 16.06.1998 DE 19826827
(43) Veröffentlichungstag der Anmeldung: 04.04.2001
(73) Patentinhaber: Infineon Technologies AG, 81669 München (DE)
(72) Erfinder: BRAUN, Georg, D-80339 München (DE)
(74) Vertreter: Fischer, Volker, Dipl.-Ing.
(86) Internationale Anmeldenummer: DE9901689
(87) Internationale Veröffentlichungsnummer: WO99066509

(56) Entgegenhaltungen:
- EP-A- 0 928 004
- US-A- 5 666 305

## Beschreibung

Die Erfindung betrifft ein Schreib- und Leseverfahren für einen nichtflüchtigen Speicher, der einen ferroelektrischen Kondensator aufweist, wobei das Material zwischen den Kondensatorplatten ein Hystereseverhalten aufweist und das nichtflüchtige Speicherverhalten auf remanenten Zuständen beruht, die auch ohne von außen angelegte Spannung beibehalten werden. Zum Auslesen der gespeicherten Zustände wird von außen eine Spannung an den Kondensator angelegt und von einem Leseverstärker die vom ursprünglich gespeicherten Zustand abhängige verschobene Ladungsmenge ausgewertet, wobei ein zerstörendes Lesens erfolgt, das ein Zurückschreiben der Information erforderlich macht. Als ferroelektrisches Material dient typischerweise PZT (Blei-Zirkonium-Titanat), PLZT (mit Lanthan dotiertes PZT), SBT (Strontium-Bismut-Tantalat) oder SBTN (mit Niob dotiertes SBT). Derartige Materialien weisen Veränderungen in der Hysteresekurve auf, die durch Alterung hervorgerufen wird. Messungen an solchen ferroelektrischen Dünnschichten haben gezeigt, daß sich die Hysteresekurve, also der Zusammenhang zwischen Polarisierung und einer angelegten Spannung, verschiebt, wenn ein gespeicherter Zustand über längere Zeit aufrechterhalten wird.,Letzterer Effekt wird als "Einprägen" oder "Imprint" bezeichnet, wobei ein statisches Imprint und ein dynamisches Imprint möglich sind.

Beim statischen Imprint wird die Spannung gar nicht oder nur über einen relativ langen Zeitraum geändert und beim dynamischen Imprint erfolgt ein Übergang von einem Remanenzzustand in die Sättigung und dann wieder in denselben Remanenzzustand, was typischerweise bei mehrmaligem Lesen und Rückschreiben der gleichen Information auftritt. Um eine sichere Detektion der Speicherzustände, also einen ausreichenden Ladungsunterschied beim Lesen, zu erzielen, besteht die Möglichkeit, den Zellenkondensator zu vergrößern, was jedoch zu einer nachteiligen Vergrößerung der Chipfläche führt.

Aus der europäischen Patentanmeldung 0 767 464, der US-Patentschrift 5 262 982 und IEEE Proceedings/VLSI and Computer Peripherals/VLSI and Microelectronics, Application in intelligent Peripherals and their Interconnection Networks, 8. Bis 12. Mai 1989, Seite 1 bis 20 bis 1 bis 23 sind ferroelektrische Speicher und ein zugehöriges Leseverfahren bekannt, bei denen eine Herabsetzung der Lebensdauer aufgrund der Alterungseigenschaften des ferroelektrischen Materials so weit wie möglich, zum Beispiel durch Vermeidung von Umpolarisation, vermieden wird. Hierbei handelt es sich um Alterung durch häufigen Wechsel des Speicherzustandes, beim Einprägeeffekt hingegen tritt gewissermaßen eine Alterung aufgrund eines zu seltenen Wechsels auf.

Aus der Druckschrift US 5,666,305 ist ein Schreibverfahren für einen ferroelektrischen Speicher bekannt, bei dem vor dem Einschreiben einer "1" mittels eines positiven Spannungspulses ein negativer Spannungspuls zum Löschen der alten Information angelegt wird. Das Einschreiben einer "0" entspricht dem vorgenannten Löschen der alten Information, also dem Anlegen nur eines negativen Spannungspulses.

Aus der Druckschrift EP 0 928 004 ist ein Leseverfahren für einen ferroelektrischen Speicher bekannt. In einem ersten Fall wird von einer positiven Polarität des Speicher-Ferroelektrikums - die einer gespeicherten "1" entspricht - und einer Bezugsspannung oder Ruhespannung VCC/2 ausgegangen. Zunächst wird eine positive Spannung VCC, dann eine negative Spannung VCC/4, dann die Bezugsspannung VCC/2 und dann die Differenz zwischen der Spannung VCC der Bitleitung und der Driveline-Spannung VCC/2 angelegt. In einem zweiten Fall wird von einer negativen Polarität des Speicher-Ferroelektrikums - die einer gespeicherten "0" entspricht - und einer Bezugsspannung oder Ruhespannung VCC/2 ausgegangen. Zunächst wird eine positive Spannung VCC, dann eine negative Spannung VCC/4, dann die Bezugsspannung VCC/2 und nachfolgend die Differenz zwischen der Spannung VCC der komplementären Bitleitung und der Driveline-Spannung VCC/2 angelegt.

Die der Erfindung zugrunde liegende Aufgabe besteht nun darin, ein Schreibverfahren und ein Leseverfahren anzugeben, bei dem, bei gleichbleibender Chipfläche, trotz der Alterungseigenschaften des ferroelektrischen Materials (Imprint) ein sicheres Lesen der gespeicherten Information über einen längeren Zeitraum ermöglicht wird.

Diese Aufgabe wird hinsichtlich des Schreibverfahrens durch die Merkmale des Patentanspruchs 1 und hinsichtlich des Leseverfahrens durch die Merkmale des Patentanspruchs 3 erfindungsgemäß gelöst. Die weiteren Unteransprüche betreffen bevorzugte Weiterbildungen dieses erfindungsgemäßen Verfahrens.

Die Erfindung besteht im wesentlichen darin, daß ein dynamischer Imprint dadurch verhindert oder zumindest reduziert wird, daß in einem Schreib- oder Lesezyklus immer alle Zustände der Hysteresekurve durchlaufen werden.

Im folgenden wird ein Ausführungsbeispiel der Erfindung anhand der Zeichnungen näher erläutert. Dabei zeigt
- Figur 1: ein Hysteresediagramm und seine Veränderungen durch Imprint,
- Figuren 2A - 2C: Diagramme zur Erläuterung eines erfindungsgemäßen Schreibverfahrens und
- Figuren 3A - 3D: Diagramme zur Erläuterung eines erfindungsgsmäßen Lese-Schreibverfahrens.

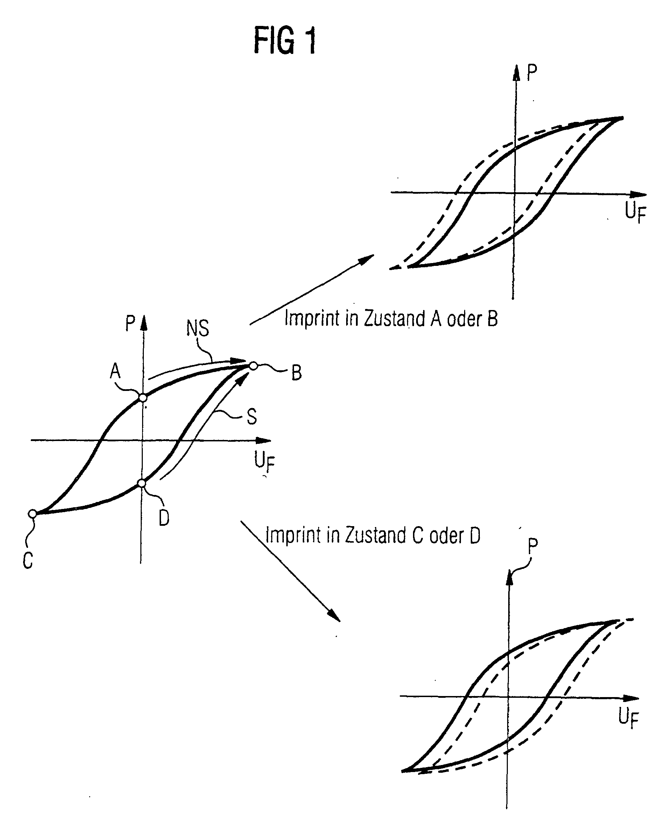

In Figur 1 ist eine Hysteresekurve für ein ferroelektrisches Dielektrikum des Speicherzellenkondensators dargestellt, wobei eine Polarisierung P über einer von außen angelegten Spannung U_{F} aufgetragen ist. Ein positiver Remanenzwert bei der Spannung U_{F} = 0 wird mit A und ein negativer Remanenzwert bei der Spannung U_{F} = 0 ist mit D bezeichnet. Ein positiver Sättigungswert ist mit B und ein negativer Sättigungswert ist mit C bezeichnet. Ein nicht schaltender Übergang NS findet beispielsweise zwischen den Punkten A und B und ein schaltender Übergang S findet beispielsweise zwischen den Punkten D und B statt, wobei beim nichtschaltenden Übergang eine geringere Ladungsmenge verschoben wird als beim schaltenden Übergang. Darüber hinaus kommt in Figur 1 zum Ausdruck, daß die Hysteresekurve in Richtung negativer spannungswerte verschoben wird, sofern überwiegend positive Polarisationswerte auftreten und daß die Hysteresekurve in Richtung politiver Spannungs verschoben wird, sofern überwiegend negative Polarisationswerte auftreten. Das bedeutet, daß mit zunehmender Alterung des Speicherbausteins das Signal, das durch den Leseverstärker bewertet wird, abnimmt oder daß es im Extremfall sogar zu einer Fehlbewertung des ausgelesenen Signals kommt. Ein weiteres Problem stellt die mit dem Imprint verbundene Verschiebung der Koerzitivspannungen, also bei Spannungen, bei denen die Hysterese die Polarität 0 aufweist, dar. Um das ferroelektrische Material genügend weit in die Sättigung treiben zu können, muß die angelegte Spannung die Koerzitivspannung um einen bestimmten Faktor übersteigen, z. B. um den Faktor 2. Wird der Betrag einer Koerzitivspannung durch Imprint stark erhöht, so tritt bei Niederspannungsanwendungen durchaus auf, daß die an den ferroelektrischen Kondensator angelegte Spannung U_{F} nicht mehr ausreicht, das Material in die Sättigung zu treiben. Dies bedeutet, daß ein bestimmter remanenter Zustand A oder D nicht mehr zuverlässig in den Speicherkondensator eingeschrieben werden kann, was ebenfalls zu einer Fehlbewertung beim Lesen des Kondensators führen kann.

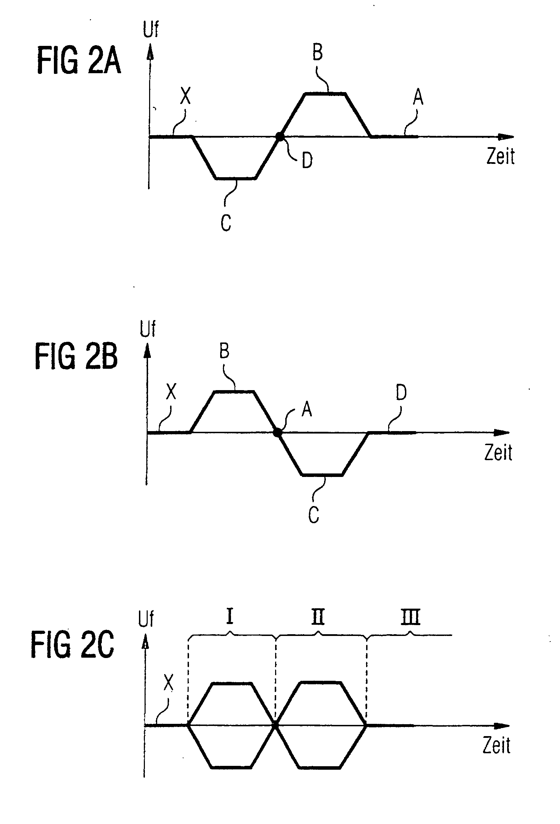

Figur 2A zeigt den zeitlichen Verlauf der Spannung U_{F} beim erfindungsgemäßen Einschreiben des Zustandes A ausgehend von einem beliebigen Zustand X. Hierbei werden entsprechend der Bezeichnungen von Figur 1 die Zustände C, D, B und schließlich A ausgehend vom Zustand X der Reihe nach eingenommen. Entsprechend ist in Figur 2B der zeitliche Verlauf der Spannung U_{F} zum Einschreiben des Zustandes D gezeigt, wobei ausgehend vom beliebigen Zustand X die Zustände B, A, C und D der Reihe nach eingenommen werden. Entsprechend dem Diagramm von Figur 1 ist die Spannung in U_{F} im Zustand C negativ und im Zustand B positiv.

In Figur 2C ist das Schreibverfahren unabhängig vom einzuschreibenden Zustand in drei Abschnitte I-III eingeteilt, wobei im Schritt I ein Einschreiben einer komplementären Information zur Beseitigung der Materialalterung in Bezug auf Imprint erfolgt, wobei im zweiten Schritt ein Einschreiben der eigentlichen Information und wobei im Schritt III eine Rückkehr zur Spannung U_{F} = 0 erfolgt, um die remanenten Zustände A bzw. D zu erreichen und um einen statischen Imprint zu vermeiden.

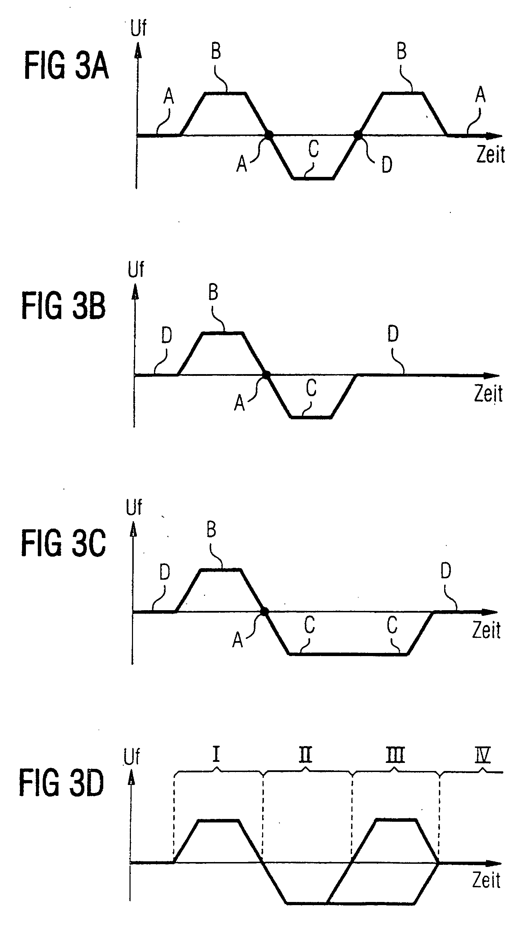

In Figur 3A ist der Verlauf von U_{F} zum Lesen und Zurückschreiben des Zustandes A dargestellt. Um den Zustand des Materials zu lesen, wird es zuerst in positive Sättigung, also in den Zustand B, gebracht, wo eine Bewertung der geflossenen Ladung durch einen Leseverstärker erfolgt, wobei der Zustand A aufgrund der im nichtschaltenden Übergang NS fließenden geringeren Ladung als beim schaltenden Übergang S den Zustand A als gespeicherten Zustand erkennt. Um den Imprint zu beseitigen, wird nun durch eine negative Spannung U_{F} der Zustand C eingenommen. Um nun den Ausgangszustand A wieder zurückzuschreiben, wird nun mit einer positiven Spannung U_{F} der Zustand B eingenommen, der nach dem Absinken von U_{F} auf 0V in den Zustand A endet.

In Figur 3B ist der zeitliche Verlauf der Spannung U_{F} zum Lesen und Zurückschreiben des Zustandes D dargestellt. Um den Zustand des Materials im Zellenkondensators zu lesen, wird es zuerst in die positive Sättigung, also in den Zustand B, gebracht, wobei die positive Sättigung gleichzeitig den Imprint im Material beseitigt, da die positive Sättigung komplementär zur vorher gespeicherten negativen Remanenz, also dem Zustand D, ist. Im Zustand B erfolgt die Bewertung der geflossenen Ladung, wobei aufgrund der im schaltenden Übergang S größeren Ladungsmenge als beim nichtschaltenden Übergang NS der Zustand D als gespeicherter Zustand erkannt wird. Um die zerstörte Information, also den Zustand D, wieder zurückzuschreiben, wird durch einen negativen Wert von U_{F} der Zustand C eingenommen, der nach dem Absinken von U_{F} auf 0V im Zustand D endet.

Um den Lesevorgang für beide Ausgangszustände A und D vorteilhafterweise gleich gestalten zu können, wird, wie in Figur 3C gezeigt, das Zurückschreiben der Information über die negative Sättigung, also den Zustand C, um eine Zyklusperiode verlängert und der gesamte Lesevorgang kann für beide Ausgangszustände A und D, wie in Figur 3D gezeigt, in vier gleich lange dauernde aufeinander folgende Abschnitte I...IV eingeteilt werden.

Im Schritt I erfolgt ein Auslesen und Bewerten der Information im Zustand B, wobei gleichzeitig eine Beseitigung des Imprints erfolgt, falls der Ausgsngszustand D war. Im Schritt II wird der Imprint beseitigt für den Fall, daß der Ausgangszustand A war oder die Information zurückgeschrieben, falls der Ausgangszustand B war. Im Schritt III erfolgt für beide Ausgangszustände, also für den Zustand A oder D ein Zurückschreiben der Information. Im Schritt IV erfolgt schließlich ein Absenken der Spannung am ferroelektrischen Kondensator auf U_{F} = 0V zur Vermeidung eines statischen Imprints.

Das erfindungsgemäße Verfahren kann nicht nur mit dem positiven Sättigungszustand B, sondern auch mit dem negativen Sättigungszustand C erfolgen, wobei die Spannungsverläufe zum Schreiben und Lesen lediglich ein anderes Vorzeichen aufweisen.

Im Idealfall ist der Betrag der Spannung U_{F} im Zustand B und im Zustand C gleich groß und führt zur größten Reduzierung bzw. zu einer Verhinderung des dynamischen Imprints.

## Patentansprüche

1. Schreibverfahren für einen ferroelektrischen Speicher, bei dem jeweils vor dem Einschreiben (II) einer eigentlichen Information ein Einschreiben einer dazu komplementären Information (I) erfolgt.

2. Schreibverfahren nach Anspruch 1, bei dem zusätzlich nach dem Einschreiben (II) der eigentlichen Information noch ein Einschreiben (III) mit einer Schreibspannung (U_{F}) gleich Null erfolgt.

3. Leseverfahren für einen ferroelektrischen Speicher, bei dem, in einem ersten Fall, ausgehend von einer positiven/negativen Polarität (A) eine Lesespannung (U_{F}) derart angelegt wird, daß die Lesespannung zunächst positiv/negativ (B, I), dann negativ/positiv (C, II) und wieder positiv/negativ (III) wird, bevor sie schließlich am Ende des Lesevorgangs wieder den Wert (IV) Null annimmt, und bei dem, in einem zweiten Fall, ausgehend von einer negativen/positiven Polarität (D), bei einer Lesespannung (U_{F}) gleich Null eine Lesespannung derart angelegt wird, daß die Lesespannung zunächst positiv/negativ (B, I) und dann negativ/positiv (C, II, III) ist, bevor sie schließlich am Ende des Lesevorgangs wieder den Wert (IV) Null annimmt.

4. Leseverfahren nach Anspruch 3, bei dem der erste und zweite Fall dadurch gleich lange dauern, daß die Lesespannung (U_{F}) im zweiten Fall länger negativ/positiv ist als beim ersten Fall.

## Claims

1. Writing method for a ferroelectric memory, in which the writing in (II) of an actual information item is in each case preceded by a writing in of an information item (I) which is complementary thereto.

2. Writing method according to Claim 1, in which the writing in (II) of the actual information item is additionally succeeded by another process of writing in (III), with a write voltage (U_{F}) equal to zero.

3. Reading method for a ferroelectric memory, in which, in a first case, proceeding from a positive/negative polarity (A), a read voltage (U_{F}) is applied in such a way that the read voltage initially becomes positive/negative (B, I), then negative/positive (C, II) and once again positive/negative (III) before it finally assumes the value (IV) of zero again at the end of the reading operation, and
in which, in a second case, proceeding from a negative/positive polarity (D), given a read voltage (U_{F}) equal to zero, a read voltage is applied in such a way that the read voltage is initially positive/negative (B, I) and then negative/positive (C, II, III) before it finally assumes the value (IV) of zero again at the end of the reading operation.

4. Reading method according to Claim 3, in which the first and second cases last the same length of time by virtue of the fact that the read voltage (U_{F}) is negative/positive for longer in the second case than in the first case.

## Revendications

1. Procédé d'écriture pour une mémoire ferroélectrique, dans lequel on effectue respectivement, avant l'écriture (II) d'une information proprement dite, une écriture d'une information (I) qui lui est complémentaire.

2. Procédé d'écriture suivant la revendication 1, dans lequel on effectue en plus, après l'écriture (II) de l'information proprement dite, également une écriture (III) avec une tension (U_{F}) d'écriture égale à zéro.

3. Procédé de lecture pour une mémoire ferroélectrique, dans lequel on applique, dans un premier cas, en partant d'une polarité (A) positive/négative, une tension (U_{F}) de lecture, en ce que la tension de lecture est d'abord positive/négative (B, I), puis négative/positive (C, II) et à nouveau positive/négative (III), avant de prendre finalement à la fin de l'opération de lecture à nouveau la valeur (IV) zéro, et dans lequel, dans un deuxième cas, en partant d'une polarité (D) négative/positive, on applique pour une tension (U_{F}) de lecture égale à zéro une tension de lecture, de sorte que la tension de lecture est d'abord positive/négative (B, I), puis négative/positive (C, II, III), avant de prendre finalement à la fin de l'opération de lecture à nouveau la valeur (IV) zéro.

4. Procédé de lecture suivant la revendication 3, dans lequel le premier et le deuxième cas ont la même durée par le fait que la tension (U_{F}) de lecture dans le deuxième cas est négative/positive plus longtemps que dans le premier cas.
